# FASCICULE DE BREVET EUROPEEN

(11) **EP 2 580 868 B1**
(45) Date de publication et mention de la délivrance du brevet: **23.04.2014**
(21) Numéro de dépôt: 11729131.0
(22) Date de dépôt: 10.06.2011
(51) Int. Cl.: H05K 13/00, B29C 45/14, H05K 5/00

(54) **PROCÉDÉ DE FABRICATION D'UNE INTERFACE DE COMMANDE POUR VÉHICULE AUTOMOBILE**
VERFAHREN ZUR HERSTELLUNG EINES STEUERSCHNITTSTELLE FÜR EINES KRAFTFAHRZEUGS
METHOD OF MANUFACTURING A CONTROL INTERFACE FOR MOTOR VEHICLE

(30) Priorité: 10.06.2010 FR 1002454
(43) Date de publication de la demande: 17.04.2013
(73) Titulaire: Valeo Systemes Thermiques, 78320 Le Mesnil Saint Denis (FR)
(72) Inventeur: GUENIN, Gérard, F-77174 Villeneuve Le Comte (FR); AUTRAN, Frédéric, F-75018 Paris (FR); BERAUD, Henry, F-94300 Vincennes (FR)
(74) Mandataire: Pothmann, Karsten
(86) Numéro de dépôt international: PCT/FR2011/000343
(87) Numéro de publication internationale: WO 2011/154627

(56) Documents cités:
- EP-A1- 2 066 162
- JP-A- 10 100 243

## Description

La présente invention concerne un procédé de fabrication d'une interface de commande pour véhicule automobile. Plus précisément, une telle interface trouve une application avantageuse pour les commandes situées à proximité du conducteur, au niveau du panneau de bord ou de la console avant d'un véhicule automobile pour par exemple commander des fonctions de climatisation, d'un système audio, d'un système de téléphonie, d'un système multimédia ou encore d'un système de navigation.

Les dispositifs de commande et d'affichage de véhicule automobile comportent un écran d'affichage pour l'affichage de données d'information ou de commande. Ces écrans peuvent être recouverts d'une dalle tactile transparente permettant la saisie de commandes par les utilisateurs du véhicule. La dalle tactile permet de déterminer les coordonnées de l'appui d'un doigt d'un utilisateur en utilisant par exemple les technologies résistive ou capacitive.

Les dalles tactiles sont des éléments minces et fragiles, laissant apparaître des bords saillants nécessitant d'être protégés et dissimulés. Pour cela, des cadres de protection sont disposés tout autour des dalles tactiles, formant un épaulement en relief. L'écran d'affichage apparaît alors en retrait.

On cherche aujourd'hui à rendre les façades de véhicule plus ergonomiques pour l'utilisateur en proposant des interfaces de commande d'aspect lisse et uniforme au toucher. EP 2066/62 A1 décrit un procédé de fabrication d'une interface de commande comportant une plaque de verre et un boîtier logeant ladite plaque de verre.

L'invention propose un procédé de fabrication d'une interface de commande pour véhicule automobile simplifié permettant d'obtenir une façade d'interface d'aspect lisse et uniforme au toucher.

A cet effet, la présente invention a pour objet un procédé de fabrication d'une interface de commande pour véhicule automobile comportant une dalle tactile présentant une face avant, et un boîtier logeant ladite dalle tactile, ledit boîtier présentant une ouverture délimitée par une bordure pour l'accès à la face avant de la dalle tactile par un utilisateur, caractérisé en ce que :
- au cours d'une première étape, on dispose l'ouverture du boîtier autour de la dalle tactile pourvue d'un film en face avant, le film couvrant au moins la face avant de la dalle tactile et les bords du boîtier,
- au cours d'une deuxième étape, on applique une force de maintien sur le boîtier pour le maintenir, et
- au cours d'une troisième étape, on introduit le matériau liquide de garniture de nivellement dans un espace périphérique cloisonné par le film, la bordure du boîtier et la tranche de la dalle tactile, pour répandre le matériau liquide de garniture de nivellement dans ledit espace périphérique.

On utilise un matériau de garniture liquide pour l'introduire à travers le boîtier dans un espace périphérique ménagé entre le film à l'avant, la bordure du boîtier et la tranche de la dalle tactile. Après polymérisation, le matériau liquide de garniture de nivellement durcit nivelant ainsi la face avant de la dalle tactile avec les bords du boîtier. Le film, nécessaire pour protéger et décorer la façade, fait également barrière à la garniture de nivellement en face avant évitant ainsi d'avoir à utiliser un moule qui aurait nécessité plusieurs étapes supplémentaires au cours de la fabrication, dont une étape de nettoyage de la garniture de nivellement en face avant via des agents de démoulage et une étape de laminage pour dérouler et plaquer le film postérieurement sur la façade de l'interface. Ainsi, le procédé est simple car il ne nécessite qu'une seule opération d'introduction du matériau de garniture liquide.

Selon un mode de réalisation particulier du procédé de fabrication :
- au cours de ladite première étape, un joint est interposé entre la face arrière de la dalle tactile et une saillie de maintien du boîtier,
- au cours de ladite deuxième étape, on applique également une force sur la saillie de maintien pour écraser le joint entre la face arrière de la dalle tactile et la saillie de maintien, et
- au cours de ladite troisième étape, on introduit le matériau liquide de garniture de nivellement dans ledit espace périphérique cloisonné par le film, la bordure et la saillie de maintien du boîtier, le joint et la tranche de la dalle tactile.

Les coulures du matériau de garniture de nivellement sont ainsi stoppées par le joint qui l'empêche de polluer la face arrière de la dalle tactile.

Selon une ou plusieurs caractéristiques du procédé de fabrication prise seule ou en combinaison :
- au cours de la deuxième étape, on écrase le joint avec un taux de compression compris entre 5% et 40%,
- le matériau de garniture de nivellement comporte une colle durcissant après exposition aux rayonnements ultraviolets,
- le matériau de garniture de nivellement comporte une silicone,
- le matériau de garniture de nivellement comporte une colle polyuréthane,
- le matériau de garniture de nivellement est introduit par injection sous une pression inférieure à 5 bars,
- le matériau de garniture de nivellement est introduit par coulage par gravité.

D'autres caractéristiques et avantages de l'invention ressortiront de la description suivante, donnée à titre d'exemple, sans caractère limitatif, en regard des dessins annexés sur lesquels :
- la figure 1 représente une vue schématique arrière d'une interface de commande sur laquelle des éléments de l'interface apparaissent en pointillés,
- la figure 2a représente une vue en coupe de côté d'une dalle tactile pourvue d'un film et d'un joint de l'interface de commande de la figure 1,
- la figure 2b représente une vue similaire à la figure 2a au cours d'une deuxième étape du procédé de fabrication d'une interface de commande,
- la figure 2c représente une vue similaire à la figure 2a au cours d'une troisième étape dudit procédé de fabrication, et
- la figure 3 représente un organigramme des différentes étapes du procédé de fabrication d'une interface de commande.

Sur ces figures, les éléments identiques portent les mêmes numéros de référence.

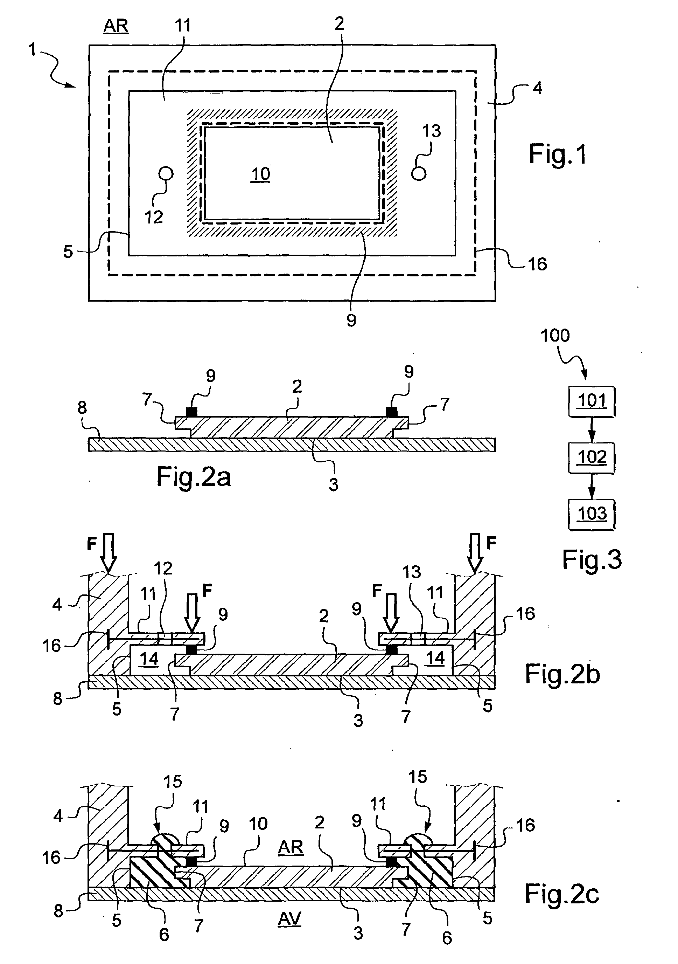

La figure 1 représente une vue schématique arrière d'une interface de commande 1 pour véhicule automobile. L'interface 1 peut être fixée à proximité de l'utilisateur, par exemple au niveau d'une console centrale du véhicule ou au niveau du panneau de bord (non représenté) pour par exemple commander des fonctions de climatisation, d'un système audio, d'un système de téléphonie, d'un système multimédia ou encore d'un système de navigation.

L'interface 1 comporte une dalle tactile 2 présentant une face avant 3 (voir figure 2b), c'est à dire orientée vers l'utilisateur pour la saisie de commandes, un boîtier 4 logeant la dalle tactile 2, ledit boîtier 4 présentant une ouverture délimitée par une bordure 5 au moins au droit de la face avant 3 de la dalle tactile pour permettre son accès à un utilisateur, et une garniture de nivellement 6 (voir figure 2c), interposée entre la tranche 7 de la dalle tactile 2 et la bordure 5 du boîtier 4.

L'interface 1 comporte également un écran d'affichage (non représenté), pour l'affichage de données d'information ou de commande, tel qu'un écran TFT (utilisant la technologie des couches minces de transistor ou « Thin film transistor » en anglais).

La dalle tactile 2 est superposée sur l'écran et comporte un capteur résistif ou un capteur capacitif, l'un ou l'autre étant au moins partiellement transparent, pour la saisie de commandes par un utilisateur. Dans le cas d'un capteur résistif, ce dernier comporte une plaque principale et d'une plaque secondaire. Ces deux plaques sont en verre, la plaque secondaire étant plus fine que la plaque principale. La plaque secondaire présente la fonction de se déformer sous une force d'appui exercée par le doigt de l'utilisateur alors que la plaque principale est moins déformable, son épaisseur est telle qu'elle ne fléchit pas sous l'effet d'une pression exercée par le doigt d'un utilisateur. Le capteur est ainsi en mesure de détecter la position du doigt de l'utilisateur grâce à un réseau de conducteurs placé entre la plaque principale et la plaque secondaire, selon une disposition par exemple horizontale et verticale. La dalle tactile 2 est reliée électriquement à une carte électronique au moyen d'un flexible multiconducteur, la carte électronique assurant l'interprétation de la détection effectuée par la dalle tactile 2.

Visible sur la figure 2c, la garniture de nivellement 6 est périphérique à la tranche 7 de la dalle tactile 2, pour niveler la face avant 3 de la dalle tactile 2 avec les bords du boîtier 4. Ainsi, la garniture de nivellement 6 met à niveau la dalle tactile 2 avec le boîtier 4 de sorte que l'utilisateur ne perçoive qu'une surface lisse et uniforme au toucher, sans aspérités ou renflements, le glissement du doigt sur la frontière entre la dalle tactile 2 et le boîtier 4 n'étant pas perceptible et pouvant en outre être rendu invisible par le choix du coloris utilisé, donnant l'impression d'une surface continue.

On utilise un matériau de garniture liquide pour l'introduire à travers le boîtier 4 dans un espace périphérique 14 ménagé entre le film à l'avant, la bordure du boîtier 4, le joint 9 et la tranche 7 de la dalle tactile 2. Après polymérisation, le matériau liquide de garniture de nivellement 6 durcit nivelant ainsi la face avant de la dalle tactile 2 avec les bords du boîtier 4.

L'interface 1 comporte un film 8 sur sa façade avant. Le film 8 couvre la face avant 3 de la dalle tactile 2 accessible à l'utilisateur (ou surface de commande), la garniture de nivellement 6 et les bords du boîtier 4, les dimensions du film 8 et les dimensions de l'interface 1 étant similaires, voire identiques.

Le film 8 présente une ou plusieurs des caractéristiques parmi lesquelles : des décors, des propriétés anti-rayure, des propriétés antireflets et diffusantes, ces dernières donnant un aspect mat à l'interface et évitant les effets miroirs gênants pour l'utilisateur, la propriété antireflet empêchant que la lumière incidente ne ressorte de la surface, des propriétés de diffusion éclatant la lumière incidente en la renvoyant dans toutes les directions, et/ou des propriétés polarisantes, c'est-à-dire susceptibles de barrer la lumière réfléchie par les plaques de verre de la dalle tactile dans une direction donnée;

L'interface 1 peut comporter un joint 9 (figure 2b), interposé entre une face arrière 10 de la dalle tactile 2 et une saillie de maintien 11 du boîtier 4, le joint 9 bordant la garniture de nivellement 6 entre la face arrière 10 de la dalle tactile 2 et la saillie de maintien 11. Lors de l'introduction du matériau liquide de garniture de nivellement 6, les coulures sont stoppées par le joint 9 qui l'empêche de polluer la face arrière 10 de la dalle tactile 2. De la sorte, les jeux de montage nécessaires entre le boîtier 4 et la dalle tactile 2 peuvent être normalement prévus sans nuire à l'étanchéité de l'interface 1. De même, des matériaux de garniture liquide peuvent être choisis parmi les plus fluides afin de mieux combler les interstices existants entre la bordure du boitier 4 et la tranche 7 de la dalle tactile 2 sans risque de fuites au cours du remplissage de l'espace périphérique 14 par le matériau liquide de garniture de nivellement 6. Les coulures dans des zones de la dalle tactile pouvant nuire à l'aspect esthétique et fonctionnel de l'interface sont ainsi évitées.

Outre sa fonction de combler les écarts de plan de la façade avant de l'interface 1, la garniture de nivellement 6 adhère au film 8 pour leurs surfaces communes. La garniture de nivellement 6 maintient également la dalle tactile 2 avec le boîtier 4 tout en conservant une certaine souplesse pour l'absorption d'éventuelles contraintes sur le boîtier 4 et protège et guide le flexible multiconducteur en partie noyé dans la garniture de nivellement 6 des vibrations du véhicule automobile ou des arêtes vives de la dalle tactile 2.

On choisit pour cela un matériau pouvant être injecté/coulé à basse pression et à faible température comme un élastomère, tel qu'un matériau EPDM (Éthylène Propylène Diène Monomère), un TPE (élastomère thermoplastique tel qu'un matériau SEBS (Styrène-éthylène-butylène-styrène), SBS (styrène-butadiène-styrène) ou TPU (Polyuréthane thermoplastique)) ou un élastomère silicone. On peut également orienter le choix de la garniture de nivellement 6 sur un matériau présentant une meilleure fluidité pour mieux combler les interstices, présentant en outre des propriétés adhésives et de souplesse, comme une silicone ou une colle durcissant après exposition aux rayonnements ultraviolets (ou colle UV) ou une colle polyuréthane. Lorsque le matériau de garniture de nivellement est polymérisé ou réticulé, par chauffage ou après un temps de séchage (silicone), ou par exposition au rayonnement ultraviolet (colle UV), ces matériaux se rigidifient, permettant un aspect lisse au toucher.

Le joint 9 comporte par exemple une mousse. La mousse 9 permet d'exercer une pression modérée sur la dalle tactile 2, évitant de lui appliquer des contraintes pouvant être interprétées comme des commandes qui pourraient nuire à son fonctionnement normal. En outre, une fois que le matériau liquide de garniture de nivellement 6 s'est durcit et que la force de maintien appliquée sur le boîtier 4 est relâchée, le joint de mousse 9 n'applique plus de contrainte sur la dalle tactile 2, qui présente alors un aspect lisse et uniforme. Le joint 9 conserve cependant une fonction d'étanchéité face à d'éventuels polluants pouvant provenir de la garniture de nivellement 6, comme du dégazage d'une silicone pouvant altérer la visibilité à travers la dalle tactile 2.

La mousse du joint 9 est à alvéoles fermées. Les alvéoles fermées permettent de garantir l'étanchéité vis-à-vis du matériau de garniture. La mousse à alvéoles fermées est par exemple en polyéthylène. La mousse du joint 9 peut aussi être en silicone ou en caoutchouc.

Selon un autre exemple, le joint 9 est moulé ou à lèvres (non représenté).

Le joint 9 peut comporter un moyen d'adhésion pour faciliter son positionnement sur la dalle tactile 2. Par exemple, le joint 9 est fixé à la dalle tactile 2 par un adhésif double face.

La saillie de maintien 11 présente une forme de cadre s'étendant de la bordure 5 du boîtier 4 vers le centre de l'ouverture. On peut aussi prévoir que la saillie de maintien 11 soit repliée à son extrémité libre pour former un épaulement intérieur et ainsi assurer la retenue du joint 9 notamment lors de l'application de la force de maintien F sur le boîtier 4 (non représenté).

Au moins un orifice d'injection 12 et au moins un trou d'évent 13 correspondant (figure 1 et 2b) sont ménagés dans la saillie de maintien 11 respectivement pour l'introduction du matériau liquide de garniture de nivellement 6 et pour l'évacuation d'air. L'air présent dans l'espace périphérique 14 à la dalle tactile 2 est chassé par l'arrivée du matériau liquide de garniture de nivellement 6 et s'échappe par le trou d'évent 13, ce qui permet de bien répandre le matériau de garniture dans tous les interstices de l'espace périphérique 14. Le surplus de matière du matériau de garniture peut s'écouler dans les zones 15 voisines de l'orifice d'injection 12 ou du trou d'évent 13 sans déborder sur les surfaces actives de la dalle tactile 2 situées à distance, et donc sans les polluer.

Pour une meilleure homogénéité de la garniture de nivellement 6, l'orifice d'injection 12 et le trou d'évent 13 peuvent être disposés sur des faces opposées du cadre.

Le boîtier 4 de l'interface 1 peut comporter au moins un moyen de renfort 16. Le moyen de renfort 16 est particulièrement utile lorsque le boîtier 4 est en matériau plastique et que la dalle tactile 2 comporte des plaques de verre. En effet, les coefficients de dilatation thermique étant différents et éloignés, le moyen de renfort 16 permet de renforcer le boîtier 4 pour éviter que, des jeux, jours ou fissures n'apparaissent à la périphérie de la dalle tactile 2 ou pour éviter le cisaillement de la garniture de nivellement 6. Le moyen de renfort 16 est un élément structurel faisant partie ou étant intégré au boîtier 4. Le moyen de renfort présente par exemple une forme de cadre, inséré dans la saillie de maintien 11 du boîtier 4. Il peut être surmoulé ou entièrement noyé dans le boîtier 4. Le moyen de renfort 16 est susceptible de renforcer la tenue mécanique du boîtier 4 pour que ce dernier se dilate de la même manière que la dalle tactile 2, lorsqu'ils sont soumis à de grandes amplitudes thermiques. Par exemple, le moyen de renfort 16 est métallique, tel qu'en acier, ce qui confère au boîtier 4 la résistance mécanique nécessaire pour résister aux contraintes thermiques et mécaniques présentes dans un habitacle de véhicule automobile (entre -40°C et + 105°C).

On va maintenant décrire plus en détails les différentes étapes du procédé de fabrication 100 illustré par les figures 2a, 2b et 2c et 3.

Préalablement, la face avant 3 de la dalle tactile 2 est pourvue d'un film 8, par exemple, préencollé, et débordant de part et d'autre de ladite face avant 3. Un joint 9 peut être disposé, par exemple par adhérence, sur la face arrière 10 de la dalle tactile 2 (figure 2a).

Au cours d'une première étape 101, on place le boîtier 4 autour de la dalle tactile 2, l'ouverture du boîtier 4 étant centrée sur la dalle tactile 2, le film 8 couvrant ainsi au moins la face avant 3 de la dalle tactile 2 et les bords du boîtier 4, le joint 9 étant, le cas échéant, interposé entre la face arrière 10 de la dalle tactile 2 et une saillie de maintien 11 du boîtier 4 (figure 2b).

Au cours d'une deuxième étape 102, on applique une force de maintien F (voir flèches sur la figure 2b) sur le boîtier 4 pour le maintenir. Le cas échéant, on applique également une force de maintien F sur la saille de maintien 11, pour écraser le joint 9 contre la face arrière 10 de la dalle tactile 2. La force de maintien F est appliquée par un outillage adapté pour appliquer une légère pression. Par exemple, on écrase le joint 9 avec un taux de compression compris entre 5% et 40%. Ainsi, avec un taux au minimum de 5%, on s'assure que le joint est comprimé un minimum pour assurer une bonne étanchéité et avec un taux au maximum de 40%, on évite d'appliquer des efforts trop importants sur le film qui pourraient le déformer.

Au cours d'une troisième étape 103, on introduit le matériau liquide de garniture de nivellement 6 par l'orifice d'injection 12 débouchant de la saillie de maintien 11 dans un espace périphérique 14 cloisonné par le film 8, la bordure 5 et la saillie de maintien 11 du boîtier 4, le joint 9 et la tranche 7 de la dalle tactile 2, pour répandre le matériau de garniture dans ledit espace périphérique 14. Le film 8 fait alors office de butée frontale pour le matériau de garniture de nivellement 6. Le matériau liquide de garniture de nivellement 6 est introduit par coulage par gravité ou par injection. L'injection est réalisée à basse pression (<5bars) et facilite l'écoulement du matériau liquide de garniture de nivellement dans l'espace périphérique à remplir de l'ordre de quelques dixièmes.

Le film 8, nécessaire pour protéger et/ou décorer la façade, fait barrière à la garniture de nivellement 6, formant un moyen de blocage à l'avant, évitant ainsi d'avoir à utiliser un moule qui aurait nécessité plusieurs étapes supplémentaires au cours de la fabrication, dont une étape de nettoyage de la garniture de nivellement via des agents de démoulage et une étape de laminage pour dérouler et plaquer le film 8 postérieurement sur la façade de l'interface 1. De même, le joint 9 fait office de butée interne pour la garniture de nivellement 6 et évite notamment des étapes ultérieures de nettoyage à l'intérieur du boîtier. Ainsi, le procédé est simple car il ne nécessite qu'une seule opération d'introduction du matériau liquide de garniture de nivellement 6. Sa qualité est accrue vis-à-vis des procédés de fabrication antérieurs car ce procédé limite les risques de bavure sur les surfaces de la dalle tactile 2. En outre, on est assuré d'obtenir une surface lisse en façade de l'interface lorsqu'on enlève la force de maintien F exercée sur le joint 9.

Après polymérisation, le matériau liquide de garniture de nivellement 6 durcit. On peut accélérer la polymérisation par chauffage ou exposition au rayonnement ultraviolet selon le type de matériau choisi pour la garniture de nivellement 6.

## Revendications

1. Procédé de fabrication d'une interface de commande pour véhicule automobile comportant une dalle tactile présentant une face avant, et un boîtier logeant ladite dalle tactile, ledit boîtier présentant une ouverture délimitée par une bordure pour l'accès à la face avant de la dalle tactile par un utilisateur, **caractérisé en ce que** :
- au cours d'une première étape (101), on dispose l'ouverture du boîtier autour de la dalle tactile pourvue d'un film en face avant, le film couvrant au moins la face avant de la dalle tactile et les bords du boîtier,
- au cours d'une deuxième étape (102), on applique une force de maintien sur le boîtier pour le maintenir, et
- au cours d'une troisième étape (103), on introduit le matériau liquide de garniture de nivellement dans un espace périphérique cloisonné par le film, la bordure du boîtier et la tranche de la dalle tactile, pour répandre le matériau liquide de garniture de nivellement dans ledit espace périphérique.

2. Procédé de fabrication selon la revendication 1, **caractérisé en ce que**
- au cours de ladite première étape (101), un joint est interposé entre la face arrière de la dalle tactile et une saillie de maintien du boîtier,
- au cours de ladite deuxième étape (102), on applique également une force sur ladite saillie de maintien pour écraser le joint entre la face arrière de la dalle tactile et la saillie de maintien du boîtier,
- au cours de ladite troisième étape (103), on introduit le matériau liquide de garniture de nivellement dans ledit espace périphérique cloisonné par le film, la bordure et la saillie de maintien du boîtier, le joint et la tranche de la dalle tactile.

3. Procédé de fabrication la revendication 2, **caractérisé en ce qu'**au cours de ladite deuxième étape (102), on écrase le joint avec un taux de compression compris entre 5% et 40%.

4. Procédé de fabrication selon l'une des revendications 1 à 3, **caractérisé en ce que** le matériau de garniture de nivellement comporte une colle durcissant après exposition aux rayonnements ultraviolets.

5. Procédé de fabrication selon l'une des revendications 1 à 3, **caractérisé en ce que** le matériau de garniture de nivellement comporte une silicone.

6. Procédé de fabrication selon l'une des revendications 1 à 3, **caractérisé en ce que** le matériau de garniture de nivellement comporte une colle polyuréthane.

7. Procédé de fabrication selon l'une des revendications 1 à 6, **caractérisé en ce que** le matériau de garniture de nivellement est introduit par injection sous une pression inférieure à 5 bars.

8. Procédé de fabrication selon l'une des revendications 1 à 6, **caractérisé en ce que** le matériau de garniture de nivellement est introduit par coulage par gravité.

## Patentansprüche

1. Verfahren für die Herstellung einer Steuerschnittstelle für ein Kraftfahrzeug, die eine taktile Platte, die eine vordere Fläche aufweist, und ein Gehäuse, das die taktile Platte aufnimmt, umfasst, wobei das Gehäuse eine durch einen Rand begrenzte Öffnung für den Zugang zu der vorderen Fläche der taktilen Platte durch einen Anwender aufweist, **dadurch gekennzeichnet, dass**:
- während eines ersten Schrittes (101) die Öffnung des Gehäuses um die taktile Platte, die auf der vorderen Fläche mit einem Film versehen ist, angeordnet wird, wobei der Film wenigstens die vordere Fläche der taktilen Platte und die Ränder des Gehäuses abdeckt,
- während eines zweiten Schrittes (102) auf das Gehäuse eine Haltekraft ausgeübt wird, um es zu halten, und
- während eines dritten Schrittes (103) das flüssige Höhenausgleichsverkleidungsmaterial in einen durch den Film, den Rand des Gehäuses und die Schnittfläche der taktilen Platte abgeteilten Umfangsraum eingeleitet wird, um das flüssige Höhenausgleichsverkleidungsmaterial in dem Umfangsraum zu vergießen.

2. Herstellungsverfahren nach Anspruch 1, **dadurch gekennzeichnet, dass**
- während des ersten Schrittes (101) zwischen die hintere Fläche der taktilen Platte und einen Haltevorsprung des Gehäuses eine Dichtung eingefügt wird;
- während des zweiten Schrittes (102) auch eine Kraft auf den Haltevorsprung ausgeübt wird, um die Dichtung zwischen der hinteren Fläche der taktilen Platte und dem Haltevorsprung des Gehäuses einzuklemmen,
- während des dritten Schrittes (103) das flüssige Höhenausgleichsverkleidungsmaterial in den durch den Film, den Rand und den Haltevorsprung des Gehäuses, die Dichtung und die Schnittfläche der taktilen Platte abgeteilten Umfangsraum eingeleitet wird.

3. Herstellungsverfahren nach Anspruch 2, **dadurch gekennzeichnet, dass** während des zweiten Schritts (102) die Dichtung mit einem Kompressionsverhältnis im Bereich von 5 % bis 40 % eingeklemmt wird.

4. Herstellungsverfahren nach einem der Ansprüche 1 bis 3, **dadurch gekennzeichnet, dass** das Höhenausgleichsverkleidungsmaterial einen Klebstoff enthält, der nach Beaufschlagung mit Ultraviolettstrahlung härtet.

5. Herstellungsverfahren nach einem der Ansprüche 1 bis 3, **dadurch gekennzeichnet, dass** das Höhenausgleichsverkleidungsmaterial Silikon enthält.

6. Herstellungsverfahren nach einem der Ansprüche 1 bis 3, **dadurch gekennzeichnet, dass** das Höhenausgleichsverkleidungsmaterial einen Polyurethanklebstoff enthält.

7. Herstellungsverfahren nach einem der Ansprüche 1 bis 6, **dadurch gekennzeichnet, dass** das Höhenausgleichsverkleidungsmaterial durch Einspritzen unter Druck niedriger als 5 Bar eingeleitet wird.

8. Herstellungsverfahren nach einem der Ansprüche 1 bis 6, **dadurch gekennzeichnet, dass** das Höhenausgleichsverkleidungsmaterial durch Gießen mittels Schwerkraft eingeleitet wird.

## Claims

1. Method of manufacturing a control interface for a motor vehicle comprising a touch-sensitive tile having a front face and a casing housing said touch-sensitive tile, said casing having an opening delimited by a border so that a user can access the front face of the touch-sensitive tile, **characterized in that**:
- during a first step (101), the opening of the casing is positioned around the touch-sensitive tile provided with a film on the front face, the film covering at least the front face of the touch-sensitive tile and the edges of the casing,
- during a second step (102), a retaining force is applied to the casing to hold it in position, and
- during a third step (103), the liquid leveling compound is introduced into a peripheral space stopped off by the film, the border of the casing and the edge face of the touch-sensitive tile, so that the liquid leveling compound can be spread out in said peripheral space.

2. Method of manufacture according to Claim 1, **characterized in that**:
- during said first step (101), a seal is interposed between the rear face of the touch-sensitive tile and a retaining projection of the casing,
- during said second step (102), a retaining force is also applied to said retaining projection to compress the seal between the rear face of the touch-sensitive tile and the retaining projection of the casing,
- during said third step (103), the liquid leveling compound is introduced into said peripheral space stopped off by the film, the border and the retaining projection of the casing, the seal and the edge face of the touch-sensitive tile.

3. Method of manufacture according to Claim 2, **characterized in that**, during said second step (102), the seal is compressed with a compression ratio of between 5% and 40%.

4. Method of manufacture according to one of Claims 1 to 3, **characterized in that** the leveling compound contains an adhesive that hardens following exposure to ultraviolet radiation.

5. Method of manufacture according to one of Claims 1 to 3, **characterized in that** the leveling compound contains a silicone.

6. Method of manufacture according to one of Claims 1 to 3, **characterized in that** the leveling compound contains a polyurethane adhesive.

7. Method of manufacture according to one of Claims 1 to 6, **characterized in that** the leveling compound is introduced by injection at a pressure of less than 5 bar.

8. Method of manufacture according to one of Claims 1 to 6, **characterized in that** the leveling compound is introduced by pouring under gravity.
